# EUROPÄISCHE PATENTSCHRIFT

(11) **EP 1 864 557 B1**
(45) Veröffentlichungstag und Bekanntmachung des Hinweises auf die Patenterteilung: **11.05.2016**
(21) Anmeldenummer: 06723436.9
(22) Anmeldetag: 15.03.2006
(51) Int. Cl.: H05K 1/02, H05K 7/20, H01L 23/367, H01L 23/40

(54) **VERFAHREN ZUR HERSTELLUNG EINES ELEKTRONISCHEN GERÄT UND ELEKTRONISCHES GERÄT**
METHOD FOR PRODUCING AN ELECTRONIC APPLIANCE, AND CORRESPONDING ELECTRONIC APPLIANCE
PROCEDE DE PRODUCTION D'UN APPAREIL ELECTRONIQUE, ET APPAREIL ELECTRONIQUE

(30) Priorität: 22.03.2005 DE 102005013763
(43) Veröffentlichungstag der Anmeldung: 12.12.2007
(73) Patentinhaber: SEW-EURODRIVE GmbH & Co. KG, 76646 Bruchsal (DE)
(72) Erfinder: PRAUTZSCH, Harald, 73479 Ellwangen (DE)
(86) Internationale Anmeldenummer: PCT/EP2006/002359
(87) Internationale Veröffentlichungsnummer: WO 2006/099977

(56) Entgegenhaltungen:
- EP-A- 0 489 958
- US-A- 3 916 515
- US-A- 4 631 819
- US-A- 5 546 275
- PATENT ABSTRACTS OF JAPAN Bd. 014, Nr. 573 (E-1015), 19. Dezember 1990 (1990-12-19) & JP 02 249299 A (MITSUMI ELECTRIC CO LTD), 5. Oktober 1990 (1990-10-05)

## Beschreibung

Die Erfindung betrifft ein Verfahren zur Herstellung eines elektronischen Gerätes und ein elektronisches Gerät.

Aus der DE 196 01 649 A1 ist eine Anordnung zur Verbesserung der Wärmeableitung bekannt. Aus Spalte 2, Zeile 43 ebenda ist bekannt, dass elektrisch leitfähige Materialien zur Wärmeableitung mit Bauelementen in Verbindung gebracht werden können. Somit muss das elektrische Potential desjenigen metallischen Gehäusebereichs des Bauelements, welcher mit den elektrisch leitfähige Materialien zur Wärmeableitung in Verbindung steht, gleich demjenigen Potential der elektrisch leitfähigen Materialien zur Wärmeableitung sein.

Aus der US 4 631 819 ist ein spannungsarme toleranzfreie Befestigungsmethode für Leistungsteile bei PC bekannt.

Aus der DE 42 31 140 A1 und der DE 42 31 141 A1 sind Baugruppen für elektronische Steuergeräte bekannt, die Leistungsbauelemente umfassen.

Aus der DE 103 49 573 A1 ist ein Elektronikgerät mit Heizelement bekannt.

Aus der EP 0 489 958 A1 sind eine Leiterplatte und eine wärmeleitende Platte bekannt.

Aus der Dokumentation "Wacker Siliconpaste P12" der Firma Wacker-Chemie GmbH, München, vom Mai 2001 ist elektrisch isolierende Wärmeleitpaste bekannt.

Aus den Datenblättern "Philips Semiconductors Package outline" der Firma Philips Semiconductors, Eindhoven/Niederlande vom 15. September 2004 beziehungsweise 21. Januar 2003 sind die Bauformen TO-247 beziehungsweise TO-220 für Umhausungen von Halbleiterbauelementen bekannt.

Aus dem Nachschlagewerk Wikipedia, Ausgabe der englischsprachigen Version vom 20. Februar 2005, Stichwort "surface-mount technology", ist ein Verfahren zur Herstellung von surface-mount devices, kurz SMD, bekannt.

Aus der JP 02249299 A ist ein Einbauverfahren für ein wärmeabgebendes Teil in eine elektronische Vorrichtung bekannt, bei welchem das wärmeabgebende Teil mit einem Stecker vorübergehend an einem Loch in einer Leiterplatte fixiert wird, wobei Anschlussenden des Teils in Aufnahmelöcher der Leiterplatte durch Abbiegen der Spritzen eingeführt werden, wobei die Spitzen anschließend mit Lötzinn fixiert werden, wobei im Anschluss der Stecker entfernt, der abtrennbare Bereich unter dem Teil weggeschnitten und das Teil mit einer Schraube an einer eingesetzten Wärmesenke befestigt wird.

Aus der US 5 546 275 A ist eine Vorrichtung zur Montage elektrischer Module bekannt.

Der Erfindung liegt die Aufgabe zugrunde, die Fertigung von Leistungselektronik umfassenden Geräten einfacher und kostengünstiger weiterzubilden.
Erfindungsgemäß wird die Aufgabe bei dem Verfahren nach den in Anspruch 1 und bei dem elektronischen Gerät nach den in Anspruch 13 angegebenen Merkmalen gelöst.

Wichtige Merkmale der Erfindung bei dem Verfahren sind in Anspruch 1 angegeben. Insbesondere wird somit vorgeschlagen, dass es ein Herstellungsverfahren für eine Anordnung zur Wärmeableitung von auf einer Leiterplatte bestückten und zu kühlenden Halbleitern betrifft,
wobei
- in einem ersten Verfahrensschritt eine Leiterplatte mit zu kühlenden Halbleitern bestückt wird, wobei Kühlflächen der Halbleiter an einem Teilbereich einer Leiterplatte aufgelegt, insbesondere ausgerichtet, sind,
- in einem folgenden Verfahrensschritt die Leiterplatte und die Halbleiter gelötet werden,
- in einem darauf folgenden Verfahrensschritt der unter den Kühlflächen der Halbleiter angeordnete Teilbereich der Leiterplatte entfernt wird und
- in einem weiteren Verfahrensschritt die Leiterplatte mit dem Kühlkörper verbunden wird, insbesondere plan, wobei
- zwischen Kühlkörper (31) und den Kühlflächen (2) der Halbleiter ein gut wärmeleitendes Element (24) angeordnet wird, und
- ein als federndes Element ausgeführter oder mit einem solchen verbundener Niederhalter (42) angebracht wird, der die Halbleiter an das gut wärmeleitende Element (24) andrückt.

Vorteil bei der Erfindung ist, dass die Fertigung von Leistungselektronik umfassenden Geräten einfacher und kostengünstiger ausführbar ist. Insbesondere sind SMD-bestückbare Bauteile verwendbar in der Leistungselektronik und es ist somit eine Reduzierung der Fertigungskosten und eine sehr gute Wärmespreizung erreichbar. Somit ist die Entwärmung von elektronischen Bauelementen verbessert.

Von Vorteil ist weiter, dass preisgünstige Standardbauteile von verschiedenen Herstellern verwendet werden können, wodurch die Abhängigkeit von einem Lieferanten sinkt. Außerdem ist die Bestückung der Bauteile in einem kostenoptimierten, automatisierten Prozess ausführbar, nämlich insbesondere der vollautomatisierten SMD-Bestückung. Des Weiteren wird eine verbesserte Wärmespreizung mit kostengünstigen und einfachen Mitteln erreicht. Im Vergleich zur Leistungsmodultechnik gilt dies ganz besonders. Darüber hinaus wird vorteiligerweise an den Kühlkörper keine besondere Anforderung gestellt. Es kann als Kühlkörper also auch ein kostengünstiges, aber größere Unebenheiten aufweisendes Strangprofil oder Stranggussprofil verwendet werden. Der notwendige Niederhalter zum Andrücken der Halbleiter in Richtung der Normale ihrer Kühlfläche kann sehr einfach ausgeführt werden, da die Halbleiter in einer Reihe oder in einer anderen geometrisch regelmäßigen Anordnung platziert sind.

Bei einer vorteilhaften Ausgestaltung ist ein Teil hoher Wärmeleitfähigkeit, also ein gut wärmeleitendes Element, vorgesehen, das eine thermische Verbindung zwischen Halbleitern und Kühlkörper mit geringem Wärmeübergangswiderstand schafft.

Bei einer vorteilhaften Ausgestaltung ist ein Niederhalter zum Andrücken der Halbleiter an das Teil hoher Wärmeleitfähigkeit vorgesehen. Insbesondere ist das Teil hoher Wärmeleitfähigkeit aus Keramik ausgeführt, insbesondere als Keramikplatte von der Dicke der Leiterplatte, wobei die Keramikplatte zwischen Kühlkörper und Halbleitern in der durch die Leiterplatte definierten Ebene vorgesehen wird. Von Vorteil ist dabei, dass die Wärme einfach und schnell aufspreizbar ist.

Unter Ebene wird die mathematische Idealisierung verstanden, die von einer planen Oberfläche eines physikalischen Gegenstands definiert wird, indem von mikroskopischen Unebenheiten, Ausnehmungen, Verformungen, Abweichungen abgesehen wird. Die räumliche Ausdehnung der vernachlässigten mikroskopischen Besonderheiten ist dabei höchstens gleich den räumlichen Ausdehnungen, über die sich mittels Wärmeleitpaste eine sichere thermische Anbindung mit geringem Wärmeübergangswiderstand, wobei die zugehörige Wärmeleitfähigkeit wenigstens 20mal besser ist als die von Luft, bewirken lässt. Die Genauigkeit, mit der eine physikalische Oberfläche eine Ebene definiert, bestimmt die Genauigkeit, mit der zwei solche Ebenen eine bestimmte räumlich-geometrische Relation erfüllen.

Von Vorteil ist bei der Ausgestaltung, dass der Niederhalter als federndes Element ausführbar ist oder mit einem solchen verbindbar ist. Somit sind die Halbleiter mit dem federnden Element sicher, insbesondere gegen räumliches Verschieben relativ zur Leiterplatte oder zum Teil hoher Wärmeleitfähigkeit, angebracht.

Bei einer vorteilhaften Ausgestaltung wird der Niederhalter im Anschluss an die genannten Verfahrensschritte auf der Leiterplatte montiert.

Bei einer vorteilhaften Ausgestaltung ist das Verbinden der Leiterplatte mit dem Kühlkörper und die Montage des Niederhalters ein einziger gemeinsamer Verfahrensschritt. Von Vorteil ist dabei, dass Arbeitsschritte eingespart werden.

Bei einer vorteilhaften Ausgestaltung ist Wärmeleitpaste zwischen den Kühlflächen der Halbleiter und dem Teil hoher Wärmeleitfähigkeit vorgesehen. Insbesondere ist auch Wärmeleitpaste zwischen dem Kühlkörper und dem Teil hoher Wärmeleitfähigkeit vorgesehen. Somit ist der Wärmeübergang jeweils verbesserbar.

Bei einer vorteilhaften Ausgestaltung ist der Kühlkörper und das Teil hoher Wärmeleitfähigkeit einstückig ausgeführt. Von Vorteil ist dabei, dass Verfahrensschritte bei der Herstellung eingespart werden können.

Bei einer vorteilhaften Ausgestaltung wird die Leiterplatte mit den Halbleitern in einem SMD-Bestückungsverfahren bestückt. Dadurch wird die Herstellung besonders kostengünstig und Massenproduktion ermöglicht.

Bei einer vorteilhaften Ausgestaltung wird der Teilbereich der Leiterplatte nach dem Abbrechen und/oder Entfernen als Leiterplatte verwendet und mit elektronischen Bauteilen bestückt. Somit ist der Umweltschutz verbessert, weil weniger Abfall vorhanden ist.

Wichtige Merkmale der Erfindung bei dem elektronischen Gerät sind in Anspruch 13 angegeben. Insbesondere wird somit vorgeschlagen, dass es Halbleiter und einen Kühlkörper zu deren Wärmeabfuhr an die Umgebung oder ein weiteres Medium umfasst,
wobei am Kühlkörper ein Teil hoher Wärmeleitfähigkeit, insbesondere zur Durchleitung der Wärme der Halbleiter an den Kühlkörper, angeordnet ist,
wobei das Teil hoher Wärmeleitfähigkeit aus elektrisch isolierendem Material ist, eine Leiterplatte mit Halbleitern bestückt ist,
wobei Kühlflächen der Halbleiter in einer Ebene mit der Oberfläche der Leiterplatte liegen,
wobei die Oberflächen des Teils hoher Wärmeleitfähigkeit jeweils in einer Ebene liegen mit einer der Oberflächen der Leiterplatte,
wobei mindestens eine Kante der Leiterplatte, die zu einer Kante des Teils hoher Wärmeleitfähigkeit benachbart ist, Überreste einer Bruchstelle aufweist,
wobei Teile der Leiterplatte derart mit dem Kühlkörper verbunden ist, dass die Kühlflächen auf dem Teil hoher Wärmeleitfähigkeit anliegen, insbesondere plan,
wobei zwischen Kühlkörper (31) und den Kühlflächen (2) der Halbleiter ein gut wärmeleitendes Element (24) angeordnet ist, und wobei
ein als federndes Element ausgeführter oder mit einem solchen verbundener Niederhalter (42) vorgesehen ist, der die Halbleiter an das gut wärmeleitende Element (24) andrückt.

Das Teil hoher Wärmeleitfähigkeit ist vorteilhaft als gut wärmeleitendes Element insbesondere aus Keramik und/oder als Keramikplatte, ausgebildet.

Von Vorteil ist bei der Erfindung eines elektronischen Geräts, dass ein sehr kompaktes und leistungsfähiges Gerät in kostengünstiger Weise herstellbar ist.

Von Vorteil gegenüber dem Stand der Technik ist weiterhin, dass durch die Ausführung des Teils hoher Wärmeleitfähigkeit in elektrisch isolierendem Material auf eine elektrische Isolation zwischen den spannungsführenden Teilen der Halbleiter und den Kühlflächen der Halbleiter verzichtet werden kann. Dies vereinfacht den Aufbau der Halbleiter deutlich, ohne den Bereich der zulässigen Betriebsspannungen für die Halbleiter nennenswert einzuschränken.

Die vorgeschlagene vorteilhafte Ausgestaltung ermöglicht weiterhin die Verwendung eines einzigen, gemeinsamen Teils hoher Wärmeleitfähigkeit, etwa einer Keramikplatte, für die simultane Wärmeableitung von einer Mehr- oder Vielzahl von Halbleiterelementen. Dies führt zu einer deutlichen Vereinfachung der Gesamtkonstruktion und damit zu einer Kostenreduktion für die Fertigung des elektronischen Geräts nach dem Oberbegriff in Anspruch 1. Weitere Vorteile ergeben sich aus den Unteransprüchen.

Die Erfindung wird nun anhand von Abbildungen näher erläutert:

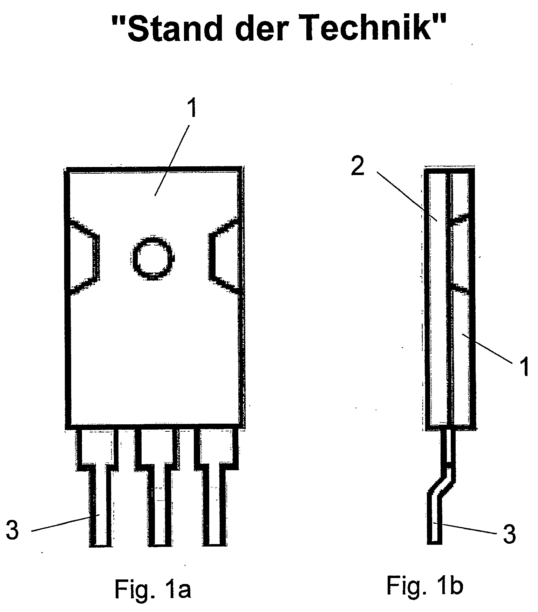

In der Figur 1 ist ein Halbleiter gezeigt. Dabei ist in Figur 1a ist der Halbleiter in Draufsicht und in der Figur 1b in Seitenansicht gezeigt. Dabei ist an der Vorderseite das Gehäuse 1 gezeigt, das das Innere des Halbleiters schützt und an der Rückseite die Kühlfläche 2 gezeigt, die die Wärme des Halbleiters abtransportieren soll. Vorzugsweise handelt es sich bei dem Halbleiter um einen MOSFET, IGBT oder anderen Leistungshalbleiter, beispielsweise in den Bauformen TO-247 oder TO-220. Mit den Anschlussbeinen 3 werden die elektrischen Kontakte hergestellt. Die Anschlussbeine 3 der Halbleiter werden vor der Bestückung auf eine SMD-bestückbare Form geschnitten und gebogen. Die Auflagefläche der Pins sind in der gleichen Ebene wie die Kühlfläche des Bauteils vorgesehen.

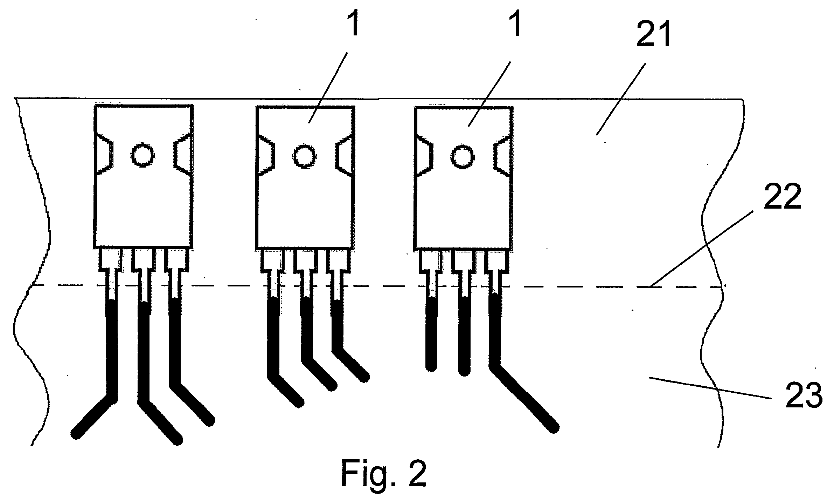

In Figur 2 ist die Leiterplatte gezeigt, die mit den Halbleitern bestückt wird. Diese Leiterplatte 23 weist einen Randbereich 21 auf, der mit einer Bruchkante 22 am Rest der Leiterplatte 23 anliegt. Während der Bestückung und dem nachfolgenden Lötvorgang bildet der Randbereich 21 eine stabile und gerade Fixierebene für die Kühlflächen der Halbleiter. Sie bleiben also alle in einer Ebene angeordnet.

Nach dem Lötvorgang wird der Randbereich 21 abgebrochen und entfernt.

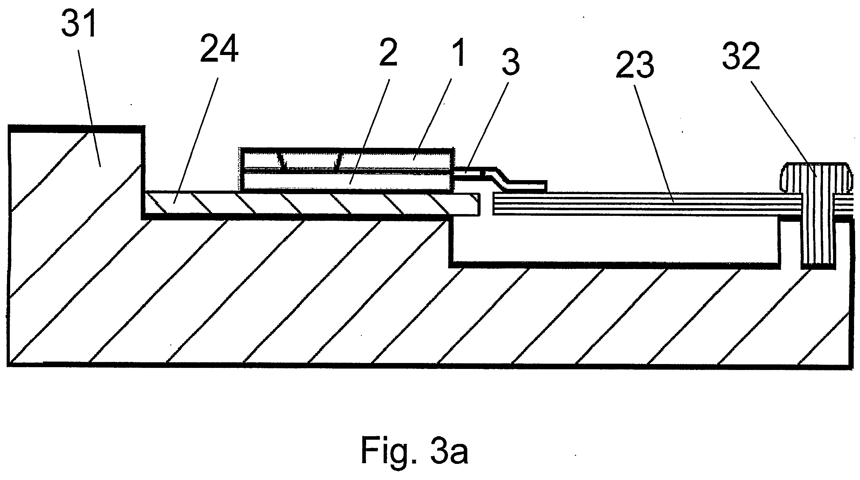

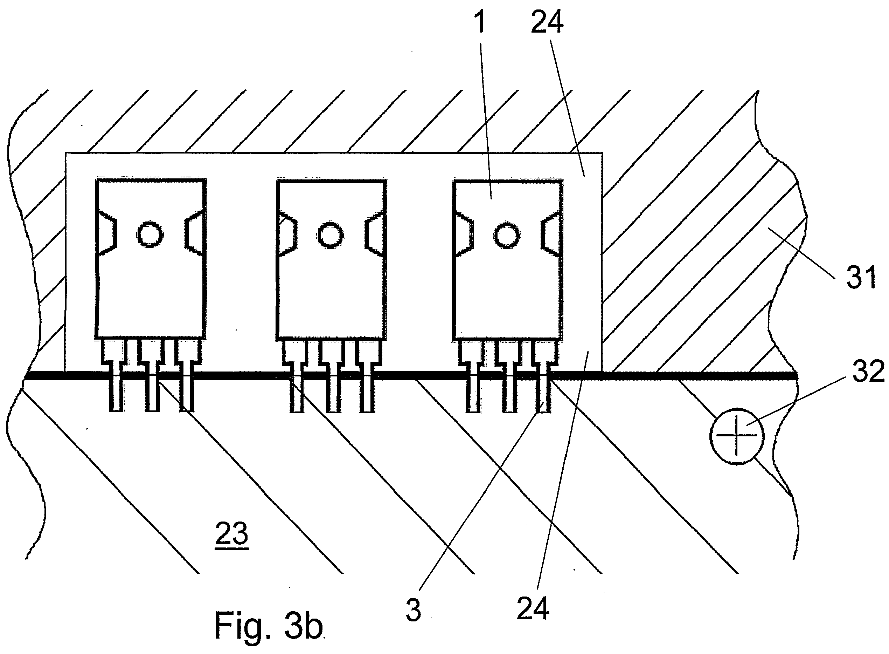

Nach dem Entfernen des Randbereiches 21 sind die Kühlflächen 2 der Halbleiter exakt auf dem Niveau der Leiterplattenoberseite. Nun wird, wie in Figur 3a als Querschnitt und in Figur 3b als Draufsicht gezeigt, die Leiterplatte 23 an einen Kühlkörper 31 angeschraubt. Dazu ist eine PE-Schraube 32 vorteilhaft verwendbar.

Auf dem Kühlkörper 31 ist eine Keramikplatte 24 vorgesehen, die die gleiche Dicke wie die Leiterplatte 23 aufweist, wodurch die Kühlflächen 2 der Halbleiter exakt anliegen an der Keramikplatte. Die Keramikplatte hat nicht nur die Aufgabe, die elektrische isolation zwischen dem Kühlkörper 31 und der Kühlfläche des Halbleiters herzustellen, sondern dient auch dem Wärmeabtransport an die Umgebung. Die Keramikplatte 24 weist eine hohe thermische Leitfähigkeit auf und gleicht auch Höhenunterschiede aus.

Die Füßchen 3 im Lötbereich und die Kühlflächen 2 der Halbleiter sind parallel zur Leiterplattenoberfläche der Leiterplatte 23 angeordnet.

Bei einer weiteren Ausführungsform ist der Randbereich 21 derart ausgeführt, dass er als Leiterplatte vorgesehen ist, die nach dem Trennen weiterverwendet wird, um Abfall und Kosten zu minimieren.

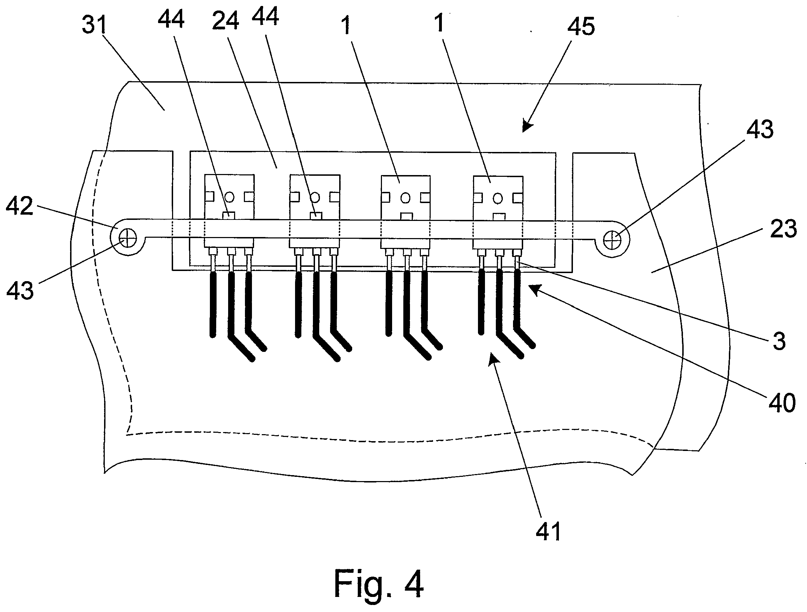

Figur 4 zeigt als erfindungsgemäßes Ausführungsbeispiel einen Ausschnitt einer Anordnung zur Entwärmung von Leistungshalbleitern eines elektronischen Geräts in Draufsicht. Auf einer Leiterplatte 23 sind Gehäuseteile 1 von Leistungshalbleitern, vorzugsweise IGBT, also insulated gate bipolar transistors, angebracht, deren Anschlussbeine 3 an Anschlusskontakten 40 mit Leiterbahnen 41 der Leiterplatte 23 verlötet sind. In Blickrichtung hinter den Gehäuseteilen 1 ist eine Keramikplatte 24 angeordnet.

Bei der Herstellung des gezeigten Ausführungsbeispiels wird nach dem Löten der Halbleiter ein Bereich der Leiterplatte herausgebrochen, wodurch ein Raumbereich 45 entsteht.
Die Keramikplatte 24 ist in diesem Raumbereich 45 angeordnet. Die Dicke der Keramikplatte 24 stimmt mit der Dicke der Leiterplatte 23 überein. Dadurch wird vorteilhaft bewirkt, dass die Gehäuseteile 1 mit ihren jeweiligen Kühlflächen automatisch, insbesondere also ohne einen zusätzlichen Verfahrensschritt, plan an der Keramikplatte 24 anliegen. Somit ist eine thermische Anbindung der Gehäuseteile 1 an die Keramikplatte 24 und weiter an den Kühlkörper 31 mit geringem Wärmeübergangswiderstand geschaffen.

Diese Keramikplatte 24 bewirkt eine gut wärmeleitende Verbindung der Gehäuseteile 1 mit dem unter Leiterplatte 23 und Keramikplatte 24 angeordneten Kühlkörper 31.

Vorzugsweise wird die Keramikplatte 24 mittels Wärmeleitpaste auf dem Kühlkörper 31angebracht. Somit ist eine direkte thermische Verbindung zwischen Keramikplatte 24 und Kühlkörper 31 mit geringem Wärmeübergangswiderstand geschaffen.

Die Keramikplatte 24 ist auf ihren Oberflächen mit einer Wärmeleitpaste bestrichen, um den Wärmeübergangswiderstand der Verbindung der Gehäuseteile 1 mit der Keramikplatte 24 sowie den Wärmeübergangswiderstand der Verbindung der Keramikplatte 24 mit dem Kühlkörper 31 möglichst gering zu gestalten.

In Blickrichtung vor den Gehäuseteilen 1 und der Leiterplatte 23 ist ein Niederhalter 42 angeordnet. Dieser Niederhalter 42 ist mit Schrauben 43 auf der Leiterplatte 23 montiert.

Die Schrauben 43 bewirken vorteilhaft gleichzeitig die mechanische Verbindung von Leiterplatte 23 mit Kühlkörper 31.

Der Niederhalter 42 drückt über Federn 44 auf die Gehäuseteile 1 und bewirkt so einerseits eine sichere räumliche Fixierung der Gehäuseteile 1 relativ zum Kühlkörper 31 und somit eine Entlastung der Lötverbindung an den Anschlusskontakten 40, andererseits einen weiter verringerten Wärmeübergangswiderstand der Verbindung der Gehäuseteile 1 mit Kühlkörper 31.

Bei einem weiteren erfindungsgemäßen Ausführungsbeispiel sind anstatt der Keramikplatte 24 entsprechende Ausformungen am Kühlkörper 31 vorgesehen, die eine direkte thermische Verbindung mit geringen Wärmeübergangswiderstand zwischen Kühlkörper 31 und Gehäuseteilen 1 schaffen.

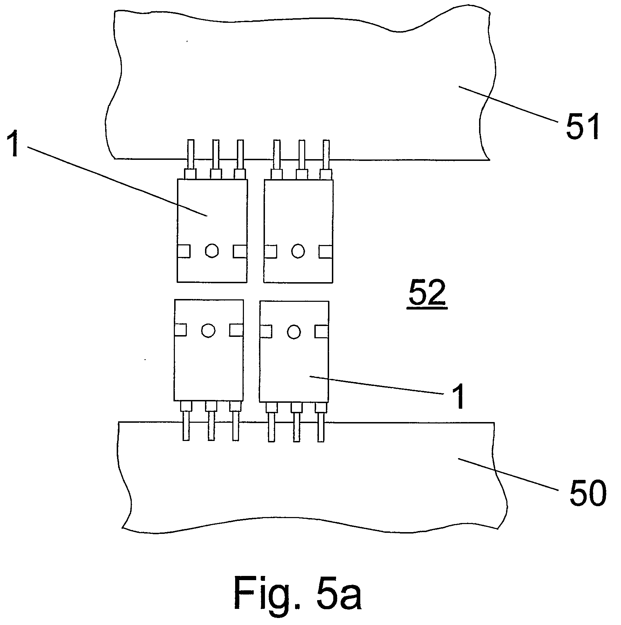

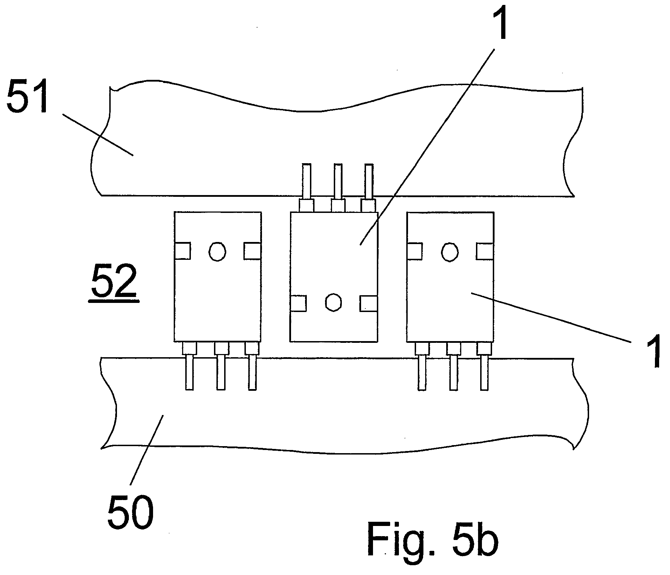

Die Figuren 5a und 5b zeigen schematisiert vereinfacht die Anordnung zur Entwärmung bei jeweils einem Ausführungsbeispiel. Diese Ausführungsbeispiele unterscheiden sich von dem in Figur 4 dargestellten zumindest durch die Anordnung der Gehäuseteile 1 relativ zueinander.

Die Gehäuseteile 1 sind, ähnlich wie in der Beschreibung zu Figur 4 ausgeführt, jeweils mit einem Träger (50, 51), vorzugsweise einer Leiterplatte, verbunden. Die Träger 50 und 51 werden von einer einzigen, zusammenhängenden Leiterplatte umfasst. Die Teile 50 und 51 sind also gegebenenfalls in Draufsicht links und rechts der Gehäuseteile miteinander verbunden. Bei einem anderen erfindungsgemäßen Ausführungsbeispiel bilden sie Bestandteile verschiedener Leiterplatten.

Der bei dem Verfahren zur Herstellung des beschriebenen Ausführungsbeispiels herausgetrennte Teilbereich der Leiterplatte oder der Leiterplatten (50, 51) hinterlässt einen schematisch dargestellten Raumbereich 52.

Die Anbindung eines hier nicht dargestellten Kühlkörpers an die Gehäuseteile 1 wird analog wie in Figur 4 vorgenommen.

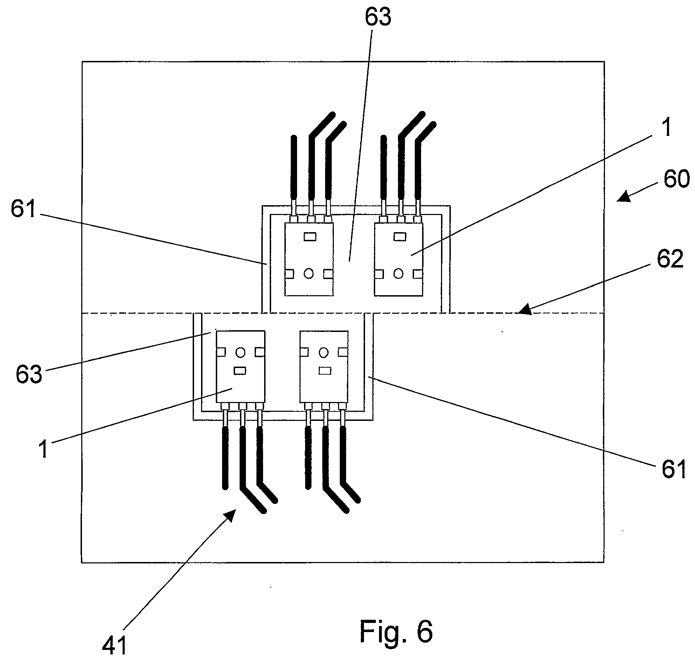

Die Figur 6 zeigt als Detail eines Ausführungsbeispiels schematisch in Draufsicht einen Nutzen 60, auf dem Gehäuseteile 1 von Halbleitern angeordnet sind, die, wie in der Beschreibung zu Figur 4 ausgeführt, über Lötkontakte mit Leiterbahnen 41 elektrisch leitend und mechanisch nicht-lösbar verbunden sind.

Der Nutzen 60 weist Ausnehmungen 61 auf, die vor Bestückung des Nutzens 60 durch Fräsen, Stanzen oder andere bei der Fertigung von Nutzen übliche Verfahrensschritte hergestellt wurden. Der Nutzen 60 weist weiter eine Sollbruchstelle 62 auf.

Die dargestellte Anordnung von Sollbruchstelle 62 und Ausnehmungen 61 bewirkt vorteilhaft, dass nach Aufbrechen der Sollbruchstelle 62 in Blickrichtung unter den Gehäuseteilen 1 gelegene Teilbereiche 63 des Nutzens von den Gehäuseteilen 1 mechanisch getrennt werden. Das Aufbrechen der Sollbruchstelle 62 bewirkt gleichzeitig, wie aus Figur 6 zu entnehmen, eine Trennung von unterer und oberer Hälfte des Nutzens 60.

Auf diese Weise lässt sich durch bloßes Aufbrechen der Sollbruchstelle 62 des bestückten Nutzens 60 eine Anordnung, hier in zweifacher Ausführung, nach dem in Figur 4 gezeigten Ausführungsbeispiel herstellen, wobei hier der Einfachheit der Darstellung halber auf die entsprechenden Niederhalter 42 und Kühlkörper 31 der Figur 4 und damit verbundene Details verzichtet wurde.

Weitere Ausführungsbeispiele ergeben sich aus dem vorstehenden Beispiel durch routinemäßiges fachmännisches Handeln, wie beispielsweise Vervielfachung der Zahl und/oder Variation des Verlaufs der Sollbruchstellen, Vervielfachung der Zahl der Gehäuseteile und/oder Variation der Anordnung derselben, insbesondere in Hinblick auf die Ausführungsbeispiele in Figur 5, Vervielfachung der Zahl der nach Aufbrechen der Sollbruchstellen entstehenden unabhängigen Anordnungen und dergleichen mehr.

In einem weiteren erfindungsgemäßen Ausführungsbeispiel ist der Kühlkörper mit der Leiterplatte stoffschlüssig, beispielsweise durch Kleben, verbunden. Von Vorteil ist dabei, dass auf Schrauben als Verbindungselemente verzichtet werden kann.

Bei einem weiteren erfindungsgemäßen Ausführungsbeispiel bei dem elektronischen Gerät sind Leiterplatte und Kühlkörper zumindest lösbar verbunden, insbesondere mittels einer Kunststoffschraube.

Bei einem weiteren erfindungsgemäßen Ausführungsbeispiel bei dem elektronischen Gerät liegen die Kühlflächen mehrerer Halbleiter an einem einzigen Teil hoher Wärmeleitfähigkeit an.

Bei einem weiteren erfindungsgemäßen Ausführungsbeispiel ist das elektronische Gerät von einem Frequenzumrichter, einem Wechselrichter oder einem Stromrichter umfasst.

Bei weiteren erfindungsgemäßen Ausführungsbeispielen ist das elektronische Gerät umfasst von einem Fernseher, einer Lichtorgel, einer Phasenanschnittsteuerung, einem Schaltnetzteil, einem Gleichstromsteller, einem Hochsetzsteller, einem elektronischen Verteiler, insbesondere in einem Automobil, oder allgemein einem Gerät mit Leistungshalbleiter, Halbleiter-Relais oder Thyristor.

Insbesondere ist die Erfindung bei solchen elektronischen Geräten vorteilhaft einsetzbar, die Leistungselektronik, insbesondere Leistungshalbleiter, sowie einen Kühlkörper mit zumindest teilweise gehäuseiaildender Funktion umfassen.

### Bezugszeichenliste

1 Gehäuseteil
2 Kühlfläche
3 Anschlussbein, Füßchen
21 Randbereich oder weitere Leiterplatte
22 Bruchkante
23 Leiterplatte
24 Keramikplatte
31 Kühlkörper
32 PE-Schraube
40 Anschlusskontakt
41 Leiterbahnen
42 Niederhalter
43 Schrauben
44 Feder
45 Raumbereich
50 Träger
51 Träger
52 Raumbereich
60 Nutzen
61 Ausnehmungen
62 Sollbruchstelle
63 Teilbereiche des Nutzens

## Patentansprüche

1. Verfahren zur Herstellung eines elektronischen Gerätes, das Halbleiter und einen Kühlkörper (31) zu deren Wärmeabfuhr an die Umgebung oder ein weiteres Medium umfasst,
wobei am Kühlkörper (31) ein Teil hoher Wärmeleitfähigkeit, insbesondere zur Durchleitung der Wärme der Halbleiter an den Kühlkörper (31), angeordnet ist,
wobei folgende Verfahrensschritte
insbesondere in der folgenden Reihenfolge ausgeführt werden:
- eine Leiterplatte (23) mit den Halbleitern in einem SMD-Bestückungsverfahren bestückt wird, wobei Kühlflächen der Halbleiter an einem Teilbereich der Leiterplatte (23) aufgelegt werden, insbesondere zum Ausrichten,
- der Teilbereich der Leiterplatte (23) entfernt wird,
- die Leiterplatte (23) mit dem Kühlkörper (31) verbunden, insbesondere lösbar verbunden, wird, wobei
- die Kühlflächen auf dem Teil hoher Wärmeleitfähigkeit anliegen, insbesondere plan,
und
**dadurch gekennzeichnet, dass**
- zwischen Kühlkörper (31) und den Kühlflächen (2) der Halbleiter ein gut wärmeleitendes Element (24) angeordnet wird, und
- ein als federndes Element ausgeführter oder mit einem solchen verbundener Niederhalter (42) angebracht wird, der die Halbleiter an das gut wärmeleitende Element (24) andrückt.

2. Herstellungsverfahren nach Anspruch 1,
**dadurch gekennzeichnet, dass**
der unter den Kühlflächen (2) der Leistungshalbleiter entfernte Teilbereich (21) der Leiterplatte (23) abgebrochen wird.

3. Verfahren nach einem der Ansprüche 1 oder 2,
**dadurch gekennzeichnet, dass**
der die Halbleiter an das gut wärmeleitende Element (24) andrückende Niederhalter (42) im Anschluss an die vorher genannten Verfahrensschritte angebracht wird.

4. Verfahren nach mindestens einem der vorangegangenen Ansprüche,
**dadurch gekennzeichnet, dass**
das Verbinden der Leiterplatte (23) mit dem Kühlkörper (31) und die Montage des Niederhalters ein einziger gemeinsamer Schritt sind.

5. Verfahren nach mindestens einem der vorangegangenen Ansprüche,
**dadurch gekennzeichnet, dass**
das Teil hoher Wärmeleitfähigkeit aus Keramik ist, insbesondere eine Keramikplatte (24) ist, und/oder der Kühlkörper (31) und das Teil hoher Wärmeleitfähigkeit einstückig ausgebildet sind.

6. Verfahren nach mindestens einem der vorangegangenen Ansprüche,
**dadurch gekennzeichnet, dass**
Wärmeleitpaste zwischen den Kühlflächen der Halbleiter und dem Teil hoher Wärmeleitfähigkeit aufgebracht wird.

7. Verfahren nach mindestens einem der vorangegangenen Ansprüche,
**dadurch gekennzeichnet, dass**
Wärmeleitpaste zwischen dem Kühlkörper (31) und dem Teil hoher Wärmeleitfähigkeit aufgebracht wird.

8. Verfahren nach mindestens einem der vorangegangenen Ansprüche,
**dadurch gekennzeichnet, dass**
der Teilbereich der Leiterplatte (23) nach dem Abbrechen und/oder Entfernen als Leiterplatte verwendet wird und mit elektronischen Bauteilen bestückt wird.

9. Verfahren nach mindestens einem der vorangegangenen Ansprüche,
**dadurch gekennzeichnet, dass**
die Leiterplatte (23) mit dem Kühlkörper (31) lösbar verbunden wird.

10. Verfahren nach mindestens einem der vorangegangenen Ansprüche,
**dadurch gekennzeichnet, dass**
zur Verbindung der Leiterplatte (23) mit dem Kühlkörper (31) eine Kunststoffschraube (32) verwendet wird.

11. Verfahren nach mindestens einem der vorangegangenen Ansprüche,
**dadurch gekennzeichnet, dass**
zur Verbindung der Leiterplatte (23) mit dem Kühlkörper (31) eine stoffschlüssige Verbindung verwendet wird.

12. Verfahren nach mindestens einem der vorangegangenen Ansprüche,
**dadurch gekennzeichnet, dass**
mindestens zwei Leiterplatten (23) zur Bestückung mit Halbleitern von einem Nutzen (60) umfasst werden,
nach der Herstellung der Lötverbindung zwischen Halbleitern und Leiterplatten die Auftrennung des Nutzens und die Heraustrennung der Teilbereiche (21) in einem einzigen Verfahrensschritt erfolgt.

13. Elektronisches Gerät, das Halbleiter und einen Kühlkörper (31) zu deren Wärmeabfuhr an die Umgebung oder ein weiteres Medium umfasst,
wobei am Kühlkörper (31) ein Teil hoher Wärmeleitfähigkeit, insbesondere zur Durchleitung der Wärme der Halbleiter an den Kühlkörper (31), angeordnet ist,
wobei das Teil hoher Wärmeleitfähigkeit elektrisch isolierend ist,
wobei eine Leiterplatte (23) mit Halbleitern im SMD-Bestückungsverfahren bestückt ist,
wobei Kühlflächen (2) der Halbleiter in einer Ebene mit einer Oberfläche der Leiterplatte (23) liegen,
wobei die Oberflächen des Teils hoher Wärmeleitfähigkeit jeweils in einer Ebene liegen mit einer der Oberflächen der Leiterplatte (23),
wobei mindestens eine Kante der Leiterplatte (23), die zu einer Kante des Teils hoher Wärmeleitfähigkeit benachbart ist, Überreste einer Bruchstelle aufweist.
**dadurch gekennzeichnet, dass**
zwischen Kühlkörper (31) und den Kühlflächen (2) der Halbleiter ein gut wärmeleitendes Element (24) angeordnet ist, und dass
ein als federndes Element ausgeführter oder mit einem solchen verbundener Niederhalter (42) vorgesehen ist, der die Halbleiter an das gut wärmeleitende Element (24) andrückt.

14. Elektronisches Gerät nach Anspruch 13,
**dadurch gekennzeichnet, dass**
die Kühlflächen (2) mehrerer Halbleiter an einem einzigen Teil hoher Wärmeleitfähigkeit anliegen.

## Claims

1. Method for producing an electronic device comprising semiconductors and a cooling body (31) for heat dissipation thereof to the surroundings or a further medium,
wherein a part of high thermal conductivity, in particular for conducting the heat of the semiconductors to the cooling body (31), is arranged on the cooling body (31),
wherein the following method steps are carried out, in particular in the following order:
- a printed circuit board (23) is populated with the semiconductors in an SMD populating method, wherein cooling surfaces of the semiconductors are placed on a partial region of the printed circuit board (23), in particular for alignment,
- the partial region of the printed circuit board (23) is removed,
- the printed circuit board (23) is connected to the cooling body (31), in particular detachably connected, wherein
- the cooling surfaces lie on the part of high thermal conductivity, in particular in a flat manner,
and
**characterised in that**
- an element (24) of good thermal conductivity is arranged between cooling body (31) and the cooling surfaces (2) of the semiconductors, and
- a holding-down device (42) formed as a sprung element or connected to such an element is attached, which device presses the semiconductors against the element (24) of good thermal conductivity.

2. Production method according to claim 1,
**characterised in that**
the partial region (21) of the printed circuit board (23) removed under the cooling surfaces (2) of the power semiconductors is broken off.

3. Method according to one of claims 1 or 2,
**characterised in that**
the holding-down device (42) pressing the semiconductors against the element (24) of good thermal conductivity is attached following the aforementioned method steps.

4. Method according to at least one of the preceding claims,
**characterised in that**
the connecting of the printed circuit board (23) to the cooling body (31) and the mounting of the holding-down device are a single common step.

5. Method according to at least one of the preceding claims,
**characterised in that**
the part of high thermal conductivity is made of ceramic, in particular is a ceramic plate (24), and/or the cooling body (31) and the part of high thermal conductivity are integrally formed.

6. Method according to at least one of the preceding claims,
**characterised in that**
heat-conducting paste is applied between the cooling surfaces of the semiconductors and the part of high thermal conductivity.

7. Method according to at least one of the preceding claims,
**characterised in that**
heat-conducting paste is applied between the cooling body (31) and the part of high thermal conductivity.

8. Method according to at least one of the preceding claims,
**characterised in that**
the partial region of the printed circuit board (23), after the breaking-off and/or removal, is used as a printed circuit board and is populated with electronic components.

9. Method according to at least one of the preceding claims,
**characterised in that**
the printed circuit board (23) is detachably connected to the cooling body (31).

10. Method according to at least one of the preceding claims,
**characterised in that**
a plastic screw (32) is used to connect the printed circuit board (23) to the cooling body (31).

11. Method according to at least one of the preceding claims,
**characterised in that**
a materially joined connection is used to connect the printed circuit board (23) to the cooling body (31).

12. Method according to at least one of the preceding claims,
**characterised in that**
at least two printed circuit boards (23) for population with semiconductors are comprised by a panel (60),
after the production of the soldered connection between semiconductors and printed circuit boards, the separation of the panel and the removal of the partial regions (21) takes place in a single method step.

13. Electronic device comprising semiconductors and a cooling body (31) for heat dissipation thereof to the surroundings or a further medium,
wherein a part of high thermal conductivity, in particular for conducting the heat of the semiconductors to the cooling body (31), is arranged on the cooling body (31),
wherein the part of high thermal conductivity is electrically insulating,
wherein a printed circuit board (23) is populated with semiconductors in the SMD populating method,
wherein cooling surfaces (2) of the semiconductors lie in a plane with a surface of the printed circuit board (23),
wherein the surfaces of the part of high thermal conductivity each lie in a plane with one of the surfaces of the printed circuit board (23),
wherein at least one edge of the printed circuit board (23), which is adjacent to an edge of the part of high thermal conductivity, has remains of a breaking point,
**characterised in that**
an element (24) of good thermal conductivity is arranged between cooling body (31) and the cooling surfaces (2) of the semiconductors, and **in that**
a holding-down device (42) formed as a sprung element or connected to such an element is provided, which device presses the semiconductors against the element (24) of good thermal conductivity.

14. Electronic device according to claim 13,
**characterised in that**
the cooling surfaces (2) of a plurality of semiconductors lie on a single part of high thermal conductivity.

## Revendications

1. Procédé de fabrication d'un appareil électronique qui comprend des semi-conducteurs et un corps de refroidissement (31) servant à dissiper la chaleur dégagée par les semi-conducteurs dans le milieu environnant ou dans un autre milieu, sachant qu'une pièce présentant une conductibilité thermique élevée et servant en particulier à transférer la chaleur des semi-conducteurs au corps de refroidissement (31) est disposée sur le corps de refroidissement (31),
sachant qu'on exécute les étapes de procédé suivantes, en particulier dans l'ordre suivant :
- une carte à circuits imprimés (23) est équipée des semi-conducteurs selon un procédé d'équipement CMS, sachant que des surfaces de refroidissement des semi-conducteurs sont placées sur une région partielle de la carte à circuits imprimés (23), notamment à des fins d'ajustage,
- la région partielle de la carte à circuits imprimés (23) est supprimée,
- la carte à circuits imprimés (23) est reliée au corps de refroidissement (31), en particulier est reliée de manière amovible,
- sachant que les surfaces de refroidissement reposent sur la pièce présentant une conductibilité thermique élevée, en particulier de manière plane,
et **caractérisé en ce que**
- un élément (24) présentant une bonne conductibilité thermique est disposé entre le corps de refroidissement (31) et les surfaces de refroidissement (2) des semi-conducteurs,
- et un serre-flan (42) est mis en place, serre-flan qui est réalisé sous forme d'élément à effet de ressort ou est relié à un tel élément, et qui presse les semi-conducteurs contre l'élément (24) présentant une bonne conductibilité thermique.

2. Procédé de fabrication selon la revendication 1, **caractérisé en ce que** la région partielle (21) de la carte à circuits imprimés (23) qui est supprimée en dessous des surfaces de refroidissement (2) des semi-conducteurs de puissance est rompue.

3. Procédé selon la revendication 1 ou 2, **caractérisé en ce que** le serre-flan (42) qui presse les semi-conducteurs contre l'élément (24) présentant une bonne conductibilité thermique est mis en place à la suite des étapes de procédé précédemment mentionnées.

4. Procédé selon au moins une des revendications précédentes, **caractérisé en ce que** la liaison de la carte à circuits imprimés (23) au corps de refroidissement (31) et le montage du serre-flan sont une unique étape commune.

5. Procédé selon au moins une des revendications précédentes, **caractérisé en ce que** la pièce présentant une conductibilité thermique élevée est en céramique, en particulier est une plaque en céramique (24), et/ou le corps de refroidissement (31) et la pièce présentant une conductibilité thermique élevée sont réalisés d'un seul tenant.

6. Procédé selon au moins une des revendications précédentes, **caractérisé en ce qu'**une pâte thermoconductrice est appliquée entre les surfaces de refroidissement des semi-conducteurs et la pièce présentant une conductibilité thermique élevée ;

7. Procédé selon au moins une des revendications précédentes, **caractérisé en ce qu'**une pâte thermoconductrice est appliquée entre le corps de refroidissement (31) et la pièce présentant une conductibilité thermique élevée.

8. Procédé selon au moins une des revendications précédentes, **caractérisé en ce que** la région partielle de la carte à circuits imprimés (23) est, à la suite de sa rupture et/ou de sa suppression, utilisée comme carte à circuits imprimés et équipée de composants électroniques.

9. Procédé selon au moins une des revendications précédentes, **caractérisé en ce que** la carte à circuits imprimés (23) est reliée de manière amovible au corps de refroidissement (31).

10. Procédé selon au moins une des revendications précédentes, **caractérisé en ce qu'**on utilise une vis en matière plastique (32) pour relier la carte à circuits imprimés (23) au corps de refroidissement (31).

11. Procédé selon au moins une des revendications précédentes, **caractérisé en ce qu'**on utilise une liaison de matière pour relier la carte à circuits imprimés (23) au corps de refroidissement (31).

12. Procédé selon au moins une des revendications précédentes, **caractérisé en ce que**
au moins deux cartes à circuits imprimés (23) à équiper de semi-conducteurs sont entourées par un flan (60),
à la suite de la réalisation de la liaison brasée entre les semi-conducteurs et les cartes à circuits imprimés, la séparation du flan et le détachement des régions partielles (21) s'effectuent en une seule étape de procédé.

13. Appareil électronique qui comprend des semi-conducteurs et un corps de refroidissement (31) servant à dissiper la chaleur dégagée par les semi-conducteurs dans le milieu environnant ou dans un autre milieu,
sachant qu'une pièce présentant une conductibilité thermique élevée et servant en particulier à transférer la chaleur des semi-conducteurs au corps de refroidissement (31) est disposée sur le corps de refroidissement (31),
sachant que la pièce présentant une conductibilité thermique élevée est électriquement isolante,
sachant qu'une carte à circuits imprimés (23) est équipée de semi-conducteurs selon un procédé d'équipement CMS,
sachant que des surfaces de refroidissement (2) des semi-conducteurs se trouvent dans un même plan avec une surface de la carte à circuits imprimés (23),
sachant que les surfaces de la pièce présentant une conductibilité thermique élevée se trouvent respectivement dans un plan avec une des surfaces de la carte à circuits imprimés (23),
sachant qu'au moins un bord de la carte à circuits imprimés (23), qui est voisin d'un bord de la pièce présentant une conductibilité thermique élevée, présente des restes d'un point de rupture,
**caractérisé en ce qu'**un élément (24) présentant une bonne conductibilité thermique est disposé entre le corps de refroidissement (31) et les surfaces de refroidissement (2) des semi-conducteurs,
et **en ce qu'**il est prévu un serre-flan (42), qui est réalisé sous forme d'élément à effet de ressort ou est relié à un tel élément, et qui presse les semi-conducteurs contre l'élément (24) présentant une bonne conductibilité thermique.

14. Appareil électronique selon la revendication 13, **caractérisé en ce que** les surfaces de refroidissement (2) de plusieurs semi-conducteurs s'appliquent contre une seule pièce présentant une conductibilité thermique élevée.
